# EUROPEAN PATENT APPLICATION

(11) **EP 4 287 246 A1**
(43) Date of publication of application: **06.12.2023**
(21) Application number: 22176657.9
(22) Date of filing: 01.06.2022
(51) Int. Cl.: H01L 21/768, H01L 23/528, H01L 23/535, H01L 29/786

(54) **A METHOD FOR PRODUCING AN INTERCONNECT RAIL FOR CONTACTING A SEMICONDUCTOR DEVICE FROM THE BACK SIDE**

(71) Applicant: Imec VZW, 3001 Leuven (BE)
(72) Inventor: Hiblot, Gaspard, 3000 Leuven (BE); Jourdain, Anne, 1390 Grez-Doiceau (BE); Van der Plas, Geert, 3000 Leuven (BE)
(74) Representative: Patent Department IMEC

(57) **Abstract**

According to the invention, an interconnect rail (34) is produced by removing the base portion (1a) of a semiconductor fin (1) selectively with respect to the material (8) around the base portion, and the resulting trench (30) is filled with an electrically conductive material, so that the rail is self-aligned to the original fin. These steps are performed after processing a top portion (1b) of the fin for producing a semiconductor device, such as a nano-sheet field effect transistor or a finFET. The fin is uniform with a semiconductor substrate (5) on whose front surface the device is produced. The device is preferably processed together with multiple other devices on multiple fins laid out in multiple patterns on a semiconductor wafer (2). The rail is obtained by thinning the wafer from the back side after front side processing, and selectively removing the base portion (1a) of the fin to form the trench (30), followed by locally exposing one terminal (15, 16) of the device and filling the trench so that said terminal is connected through the rail (34) to the back side of the thinned wafer.

## Description

### Field of the Invention

The present invention is related to semiconductor processing, in particular to the connectivity of nano-scaled semiconductor devices to the backside of the semiconductor substrate onto which said devices have been fabricated.

### State of the art.

The connection of transistors and other active semiconductor devices formed on the front side of a substrate towards the back side of the substrate has become a widely studied subject in the field of 3D integration of semiconductor components such as integrated circuit chips. In this context, buried interconnect rails have been developed. These rails are elongate electrical conductors which are at least partially buried in the substrate and which are connected at their front side to a plurality of active devices and at the back side to a plurality of through semiconductor vias (TSVs) which connect the rails (and thereby the devices) to the back side of the substrate. These rails are more commonly known by the name 'buried power rails' (BPR), in view of the main field of application of these structures, which is to connect the devices to a power delivery network formed entirely on the back side of the substrate. A more detailed description of BPRs and methods for producing them can be found in many prior art publications, an example of which is patent publication document EP3324436A1.

Currently, a buried interconnect rail is produced adjacent to a row of active devices, or in between two parallels rows of devices, and the connections of the front side of the rail to the devices are realized through local interconnects which may be partially formed in the lowest metallization level of the multi-level interconnect structure (usually referred to as the back end of line portion) of an integrated circuit chip. This approach however represents an important consumption of chip surface space, which is counteracting the continuing trend towards scale reduction in semiconductor processing.

Another issue with current BPR-designs is that the TSVs are often formed after the formation of the rails and after thinning the wafer onto which the active devices have been processed and bonding the thinned wafer face down to a carrier wafer. The thinning and bonding processes cause distortions of the thinned wafer which make it difficult to properly align the TSVs to the rails.

### Summary of the invention

The invention aims to provide a solution to the above-identified problems. This aim is achieved by a method and by components and structures in accordance with the appended claims.

According to the invention, an interconnect rail is produced by removing the base portion of a semiconductor fin selectively with respect to the material around the base portion, and the resulting trench is filled with an electrically conductive material, so that the rail is self-aligned to the original fin. These steps are performed after processing a top portion of the fin for producing a semiconductor device, such as a nano-sheet field effect transistor or a finFET. The fin is uniform with a semiconductor substrate on whose front surface the device is produced. The device is preferably processed together with multiple other devices on multiple fins laid out in multiple patterns on a semiconductor wafer. The rail is obtained by thinning the wafer from the back side after front side processing, and selectively removing the base portion of the fin to form the trench, followed by locally exposing one terminal of the device and filling the trench so that said terminal is connected through the rail to the back side of the thinned wafer. Depending on the type of device, care must be taken to ensure proper isolation of the rail from the current-conducting portions of the device.

The self-aligned rails do not require dedicated surface space on the wafer, thereby realizing an improvement in terms of area-related efficiency of the components (ICs or other types of semiconductor chips), produced from the thinned wafer. In addition, as the rails are produced after thinning the wafer and bonding it to a carrier substrate, the prior art problems related to distortions due to thinning and bonding are avoided.

The invention is in particular related to a method for producing an interconnect rail that is electrically connected to a semiconductor device comprising at least two terminals for conducting current into or out of the device, wherein the device is produced on the front side of a semiconductor wafer by processing a top portion of a semiconductor fin comprising said top portion and a base portion that is uniform with the semiconductor wafer and that is embedded in a dielectric material, and wherein the interconnect rail is configured to connect a terminal of the device to the back side of a substrate obtained by thinning the wafer, characterized in that the production of the interconnect rail takes place after producing the device and thinning the wafer, and includes removing the base portion of the fin selectively with respect to the dielectric material and filling a trench obtained by said selective removal, to thereby form the interconnect rail, so that the rail is aligned to the top portion of the fin.

According to an embodiment, a dielectric liner is produced on the sidewalls and the bottom of the trench, and the liner is locally removed on the bottom of the trench to thereby expose a terminal of the device prior to filling the trench. According to one case of the latter embodiment:
- the device is a nano-sheet field effect transistor,
- said terminals include a source terminal and a drain terminal,
- the source and drain terminal each comprise a doped semiconductor region in said top portion of the fin, and a contact formed at least on top of said doped semiconductor region,
- the doped semiconductor regions are formed directly on the base portion of the fin, so that said regions are exposed at the bottom of the trench,
- the device further comprises :
   ▪ a channel between the source and drain regions, and configured to conduct current in the direction of the fin, through a plurality of nano-sheets formed of the semiconductor material of the substrate,
   ▪ a gate wrapped around the nano-sheets and separated from the channel by a gate dielectric,
- after depositing the liner on the sidewalls and the bottom of the trench, the liner is locally opened in an area overlapping one of said doped semiconductor regions, thereby exposing at least part of said region,
- the material of the doped semiconductor region is at least partially transformed into a first electrically conductive material, prior to filling the trench with a second electrically conductive material to thereby form the interconnect rail.

According to an embodiment, a via opening is locally produced at the bottom of the trench, to thereby expose a terminal of the device, prior to filling the trench.

According to one case of the latter embodiment:
- the device is a finFET transistor,
- said terminals include a source terminal and a drain terminal,
- the source and drain terminals each comprise a doped semiconductor region in said top portion of the fin, and a contact formed at least on top of said region,
- the device further comprises :
   ▪ a channel between the source and drain regions, and configured to conduct current in the direction of the fin,
   ▪ a gate separated from the channel by a gate dielectric,
- the via opening is produced through the bottom of the trench, overlapping one of said doped semiconductor regions,
- a dielectric liner is deposited on the sidewalls and bottom of the trench and of the via opening,
- the liner is removed from a part of the bottom of the via opening, thereby exposing at least part of one of said doped semiconductor regions,
- the material of the doped semiconductor region is partially transformed into a first electrically conductive material, prior to filling the via opening and the trench with a second electrically conductive material to thereby form the rail.

Acording to an embodiment, the doped semiconductor regions are silicon regions, and the material of said exposed region is transformed into a metal silicide, by depositing a metal layer and by allowing the metal to react with the silicon of said exposed region.

Acording to an embodiment, the semiconductor wafer is formed of a base wafer, an etch stop layer and a substrate, and wherein the fin is uniform with the substrate, and wherein thinning the wafer comprises removing the base wafer and the etch stop layer relative to the substrate.

The invention is equally related to a semiconductor component comprising:
- a semiconductor substrate,
- a device on the front side of the substrate, the device comprising at least two terminals for conducting current into or out of the device,
- an interconnect rail buried in the substrate and oriented parallel to the current flow direction between the terminals,
characterized in that the terminals are located above the rail and aligned thereto along said flow direction, and wherein one of the terminals is electrically connected to the rail.

Acording to an embodiment of the component according to the invention :
- the device is a nano-sheet field effect transistor,
- said terminals include a source terminal and a drain terminal,
- the device further comprises :
   ▪ a channel between the source and drain regions, and configured to conduct current in the direction of the fin, through a plurality of nano-sheets formed of the semiconductor material of the substrate,
   ▪ a gate wrapped around the nano-sheets and separated from the channel by a gate dielectric.

Acording to another embodiment of the component according to the invention
- the device is a finFET transistor,
- said terminals include a source terminal and a drain terminal,
- the device further comprises :
   ▪ a channel between the source and drain regions, and configured to conduct current in the direction of the fin,
   ▪ a gate separated from the channel by a gate dielectric.

### Brief description of the figures

Figures 1a to 1h illustrate the method of the invention according to a first embodiment, wherein an interconnect rail is produced for contacting a nano-sheet field effect transistor (FET) from the back side.
Figures 2a to 2i illustrate a second embodiment, wherein an interconnect rail is produced for contacting a finFET from the back side.
Figures 3 and 4 illustrate a self-aligned interconnect rail produced according to the invention, respectively on the back side of an array of nano-sheet FETs and an array of finFETs.

### Detailed description of the invention

In the following detailed description, two representative embodiments of the invention are described in terms of the type of semiconductor device to which the embodiments in question are related. It is to be noted however that the invention is not limited to these particular embodiments, nor to any of the materials or dimensions cited in the following paragraphs.

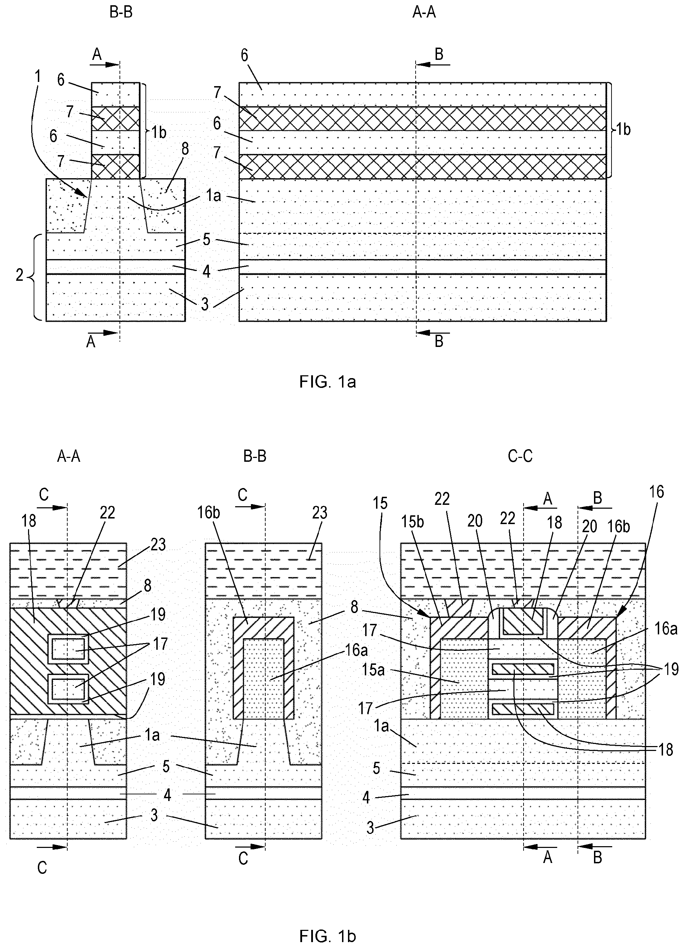

With reference to Figure 1a, the starting point for the method of the invention according to a first embodiment is a semiconductor fin 1 comprising a base portion 1a and a top portion 1b. The base portion 1a is uniform with a semiconductor wafer 2, comprising a base silicon wafer 3, a SiGe etch stop layer 4, and a silicon top layer 5. The base portion 1a of the fin 1 is uniform with the top layer 5 of the wafer 2. The fin 1 further comprises a top portion 1b formed of a stack of layers, commonly referred to as nano-sheets, which typically consists of a sequence of alternating Si layers 6 and SiGe layers 7. The base portion 1a of the fin is embedded (i.e. surrounded by and in contact with on both sides) in a dielectric layer 8, typically a layer of SiO₂. This structure is well-known in the art, and methods for producing it are equally known and need not be described here in detail. Although a single fin 1 is shown, the fin is normally one of an array of multiple parallel fins. Large numbers of such arrays are produced simultaneously on the wafer 2. The base wafer 3 may be a silicon process wafer of 200mm or 300mm in diameter, onto which several integrated circuit chips are to be built, each chip comprising thousands of active devices built on and around the fins 1.

The width of the fin 1 may be in the order of a few nm up to a few tens of nm. The thickness of the nano-sheets 6 and 7 may be in the order of a few nm. In its longitudinal direction, the fin 1 may extend along any given distance in accordance with the requirements of a particular layout.

Figure 1b shows three section views of the fin 1 after processing the top portion 1b thereof to form a nano-sheet field effect transistor. The transistor comprises a source terminal 15 and a drain terminal 16, each terminal comprising a doped silicon region (15a, 16a) and a metal contact (15b, 16b) formed on top of the doped regions and wrapped around three sides thereof. In the present context as well as in the appended claims, the term 'terminal' is defined as in the previous sentence, i.e. as the combination of a doped semiconductor region and an electrically conductive contact. In this sense, the terminals act as entry points for current flowing through a semiconductor device, in this case a nano-sheet transistor.

Between the doped regions 15a and 16a, the channel 17 of the transistor is formed, consisting of two silicon nano-sheet portions. Wrapped around the nano-sheet channel portions is the metal gate 18 of the transistor, separated from the channel by the gate dielectric 19. The gate 18 is additionally separated from the source and drain by gate spacers 20. The fabrication steps for producing this type of transistor are equally well known in the art and therefore not described here in detail.

The doped regions 15a and 16a are typically obtained by removing the nanosheets locally in this area and by epitaxial growth of Si starting from the lateral surfaces of the Si nanosheets in the gate area. It is also possible however to maintain the nano-sheet structure in the source and drain areas and to apply a doping step in these areas. So in that case, the regions 15a and 16a are still falling under the term 'doped regions' which are part respectively of the source and drain terminals ('terminal' being defined as described above).

The transistor is embedded in the dielectric layer 8 which may be extended around the device by additional depositions of SiO₂. Interconnect vias 22 through said SiO₂ layer 8 are shown which connect the source contact 15b and the gate 18 to a multilayer interconnect structure represented in a simplified way as a layer 23 formed on top of the SiO₂ layer 8. This layer 23 is the back end of line (BEOL) portion of an integrated circuit of which the transistor will be one of the active devices. The contact vias 22 may be part of a first metallization level (M0), with the BEOL portion 23 comprising additional levels (M1,M2, etc) formed thereon, each having a particular design and connectivity. The layer comprising the transistor and multiple other transistors processed on the wafer surface, together with the M0 level, is generally referred to as the front end of line (FEOL) portion of the IC. On top of the BEOL layer 23, access terminals will be produced for contacting the circuit. These elements are not shown in the drawing which is only meant to present a schematic image of the elements which are relevant for the present invention. The drawings are also not drawn to scale in correspondence with a realistic device but are merely intended as schematic images that illustrate the characteristic features of the invention.

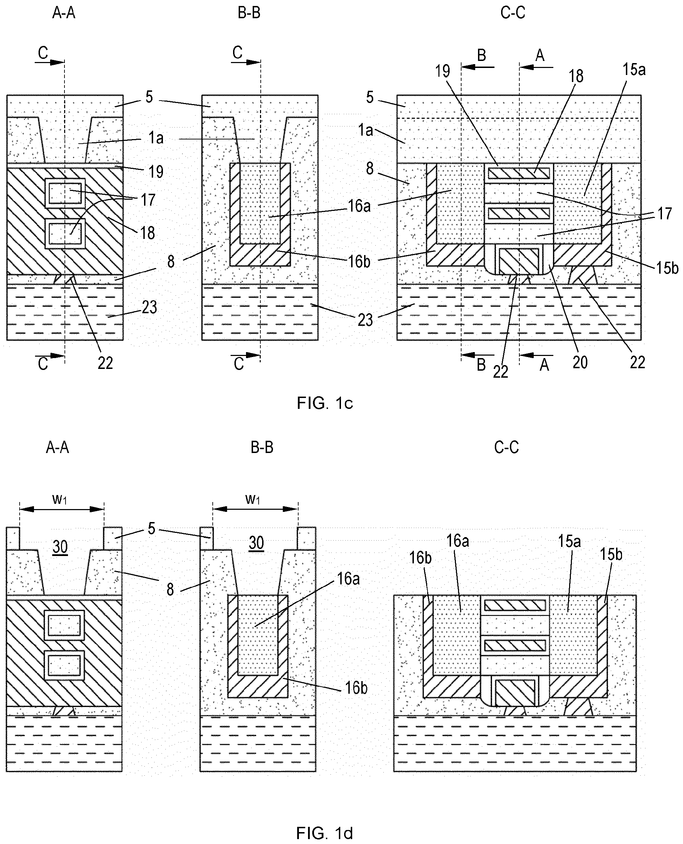

As shown in Figure 1c, the wafer is flipped and bonded to a support surface which may be the surface of a carrier wafer (not shown), before commencing the back side processing which will involve contacting the transistor's drain terminal 16 from the back side. The base wafer 3 is first thinned by grinding and/or CMP (chemical mechanical polishing), and finally by a wet etch process that stops on the etch stop layer 4. This layer is then selectively removed relative to the silicon layer 5, leaving only this layer which will hereafter be termed the substrate 5 of the eventual IC. The thickness of the substrate 5 may be in the order of a few tens of micrometers up to about a hundred micrometers.

In a step that is characteristic to the invention, the base portion 1a of the fin is selectively removed with respect to the SiO₂ layer 8, see Figure 1d. This is done by lithography and etching. By lithography, a mask is deposited and patterned, exposing a width w₁ indicated in Figure 1d, with w₁ fully overlapping the width of the base portion 1a of the fin. In the exposed area, the silicon is removed by an etch process that is selective relative to the surrounding SiO₂ 8, i.e. the silicon is removed while the SiO₂ remains essentially intact. Suitable selective etch recipes for realizing this are well-known in the art. The etch may be selective also to the material of the doped source and drain regions 15a and 16b so that the etch stops on those regions. Otherwise, a timed etch process can be used that is stopped when the silicon of the base portion 1a of the fin has been completely removed.

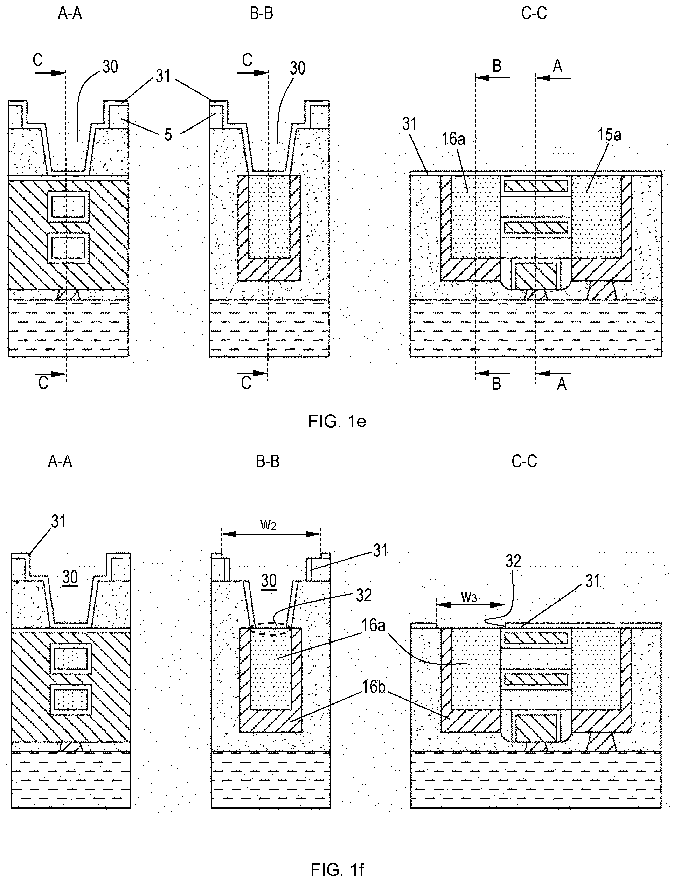

The result, as shown in Figure 1d, is a trench 30 that is self-aligned to the original fin 1. In the next step illustrated in Figure 1e, a dielectric liner 31 is deposited conformally, i.e. the liner 31 follows the topography of the surface onto which it is deposited. This liner thereby covers the bottom and the sidewalls of the trench 30, as well as the back surface of the silicon substrate 5 outside the trench 30. The liner 31 could be a layer of SiO₂ or SiN deposited for example by chemical vapour deposition.

With reference to Figure 1f, a second lithography and etching step is applied. A mask is formed and patterned, exposing a local area that overlaps the trench 30 along a width w₂ in the direction perpendicular to the original fin, and along a width w₃ in the direction of the original fin. The width w₃ overlaps the doped region 16a of the drain terminal 16 in the direction of the fin. Within this exposed area, the liner 31 is removed from all level surfaces while essentially maintaining the liner on all vertical and inclined surfaces. This may be done by a suitable plasma etch process known as such in the art and described for example in patent publication document EP3035369A1.

In reality, the liner 31 on the vertical and inclined surfaces may be slightly thinned, but this effect is not represented. As known in the art, the plasma etch can be tuned to completely remove the liner from the level surfaces while maintaining a sufficient thickness on the vertical and inclined surfaces.

As seen in Figure 1f, the plasma etch results in a local opening 32 being formed in the liner 31, exposing the doped silicon region 16a of the drain terminal 16 at the bottom of the trench 30.

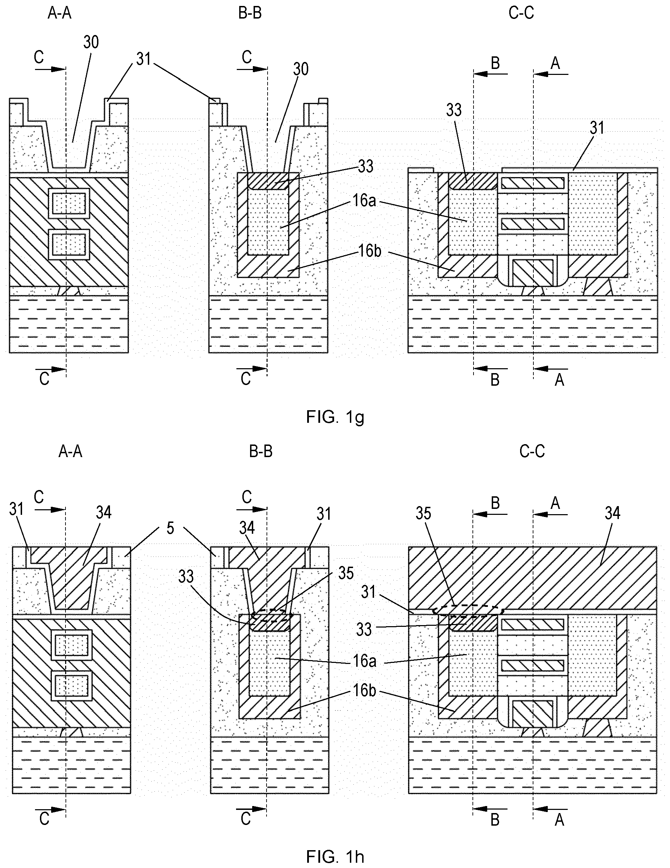

The next step consists of the silicidation of the doped silicon region 16a, illustrated in Figure 1g. This process is known as such and involves a number of substeps (not all are illustrated), starting with the deposition of a conformal layer of metal that is suitable for reacting with silicon to form an electrically conductive silicide. This may for example be a layer of nickel. The silicidation reaction takes place only in the exposed area of the doped Si region 16a, resulting in a silicide layer 33 extending into the doped region 16a down to a given depth in accordance with the thickness of the deposited reaction material and the time that has been allowed for the silicidation to take place. As the silicidation is limited to the region 16a, the gate dielectric 19 remains in place and prevents the silicide from contacting the gate 18. Non-reacted silicidation metal may then be removed relative to all underlying surfaces and relative to the formed silicide 33. Depending on the metal that was used however, it may also be possible to leave the non-reacted metal in place.

In the step shown in Figure 1h, a further metal is deposited to fill the trench 30 and the opening 32 at the bottom of the trench. If the area 33 is nickel silicide, the metal fill could be done with copper deposited for example by electrodeposition, but other known methods may be used in accordance with the choice of the materials. The filled-up trench forms a buried interconnect rail 34, while the filled-up opening 32 forms an interconnect via 35 that electrically connects the rail 34 to the silicide area 33 and hence to the drain terminal 16. After the metal fill step, the surface is planarized by grinding and/or CMP as illustrated in Figure 1h to arrive at the back side of the rail 34 being coplanar with the back side of the silicon substrate 5.

The production process of the integrated circuit is not finished at this point, but includes additional steps known as such in the art for producing a BEOL-type structure on the back side of the substrate 5. This may be a power delivery network formed on said back side and coupled to back side power terminals for the supply of power to the active devices on the front side of the IC, through a plurality of the rails 34.

The buried interconnect rail 34 produced according to the invention is self-aligned to the original fin 1, which solves the above-described problem of surface space on the chip. In addition, there is no longer a need to produce TSV openings through the substrate 5, which solves the alignment problems due to distortions of the substrate 5 after thinning and bonding. In the particular case of the nano-sheet transistor shown in the drawings, another problem is solved by the inventive approach. If the silicon base portion 1a of the fin 1 remains in the final device, this base portion is likely to act as a parasitic channel which leads to a deterioration of the device performance. In a chip produced according to the invention, the base portion 1a of the original fin is transformed into an electrically conductive area that cannot therefore form a parasitic semiconductor channel of the device.

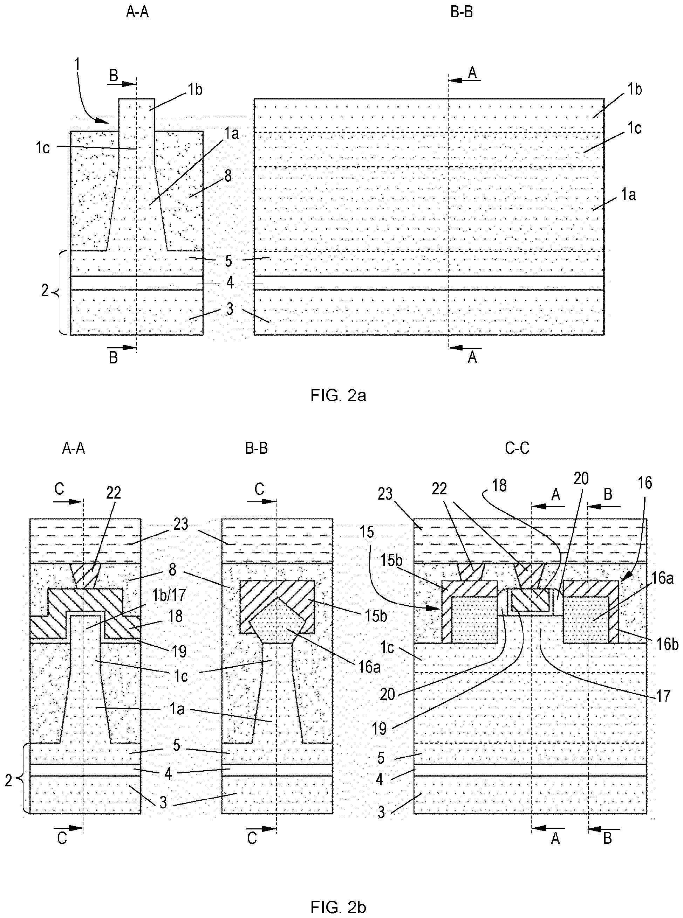

The method is not only applicable however to nano-sheet devices. Figures 2a to 2i illustrate the application of the method to a finFET transistor formed on a silicon fin 1 as illustrated in Figure 2a. Once again, the fin 1 may be one of an array of parallel fins having lateral dimensions in the order of a few nanometers to a few tens of nanometers. The fin comprises a base portion 1a, a top portion 1b and a middle portion 1c. The base portion 1a (and in this case the fin 1 as a whole) is uniform with the top silicon layer 5 of the wafer 2, comprising the base wafer 3, a SiGe etch stop layer 4 and said top layer 5. The top portion 1b extends outward from an embedding dielectric 8, which may be SiO₂. As known in the art, the finFET is built on and around the top portion 1b, resulting in the section views shown in Figure 2b. The source and drain terminals 15 and 16, each comprising a doped silicon region (15a, 16a) and a metal contact (15b, 16b), are indicated by the same reference numerals as in the nano-sheet embodiment. This is also the case for the gate 18, the gate dielectric 19 and the spacers 20, and for the channel 17, which is now formed a part of the top portion 1c of the original fin 1. Interconnect vias 22 are also numbered in the same way, as well as the embedding SiO₂ 8 and the BEOL portion 23.

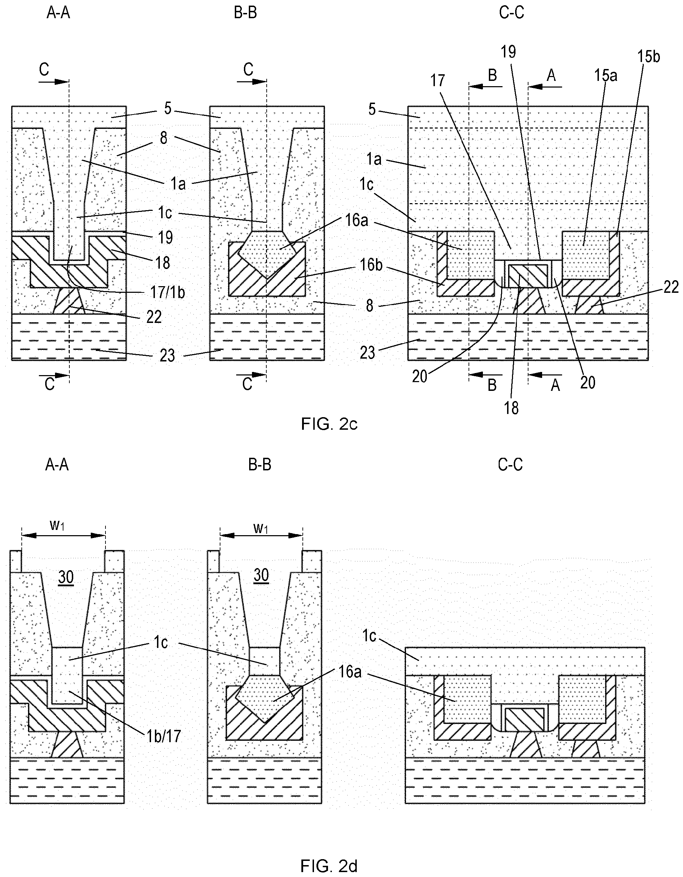

With reference to Figure 2c, flipping, bonding and thinning the wafer 2 takes place in the same manner as described above. The removal of the base portion 1a of the fin selectively with respect to the SiO₂ to create the trench 30 is illustrated in Figure 2d. This is done as in the previous embodiment by a lithography and etch step, using a mask that exposes a width w₁ overlapping the base portion 1a of the fin. As seen in the drawing, the channel 17 and the middle portion 1c of the fin are now remaining and the trench 30 is formed above said middle portion 1c.

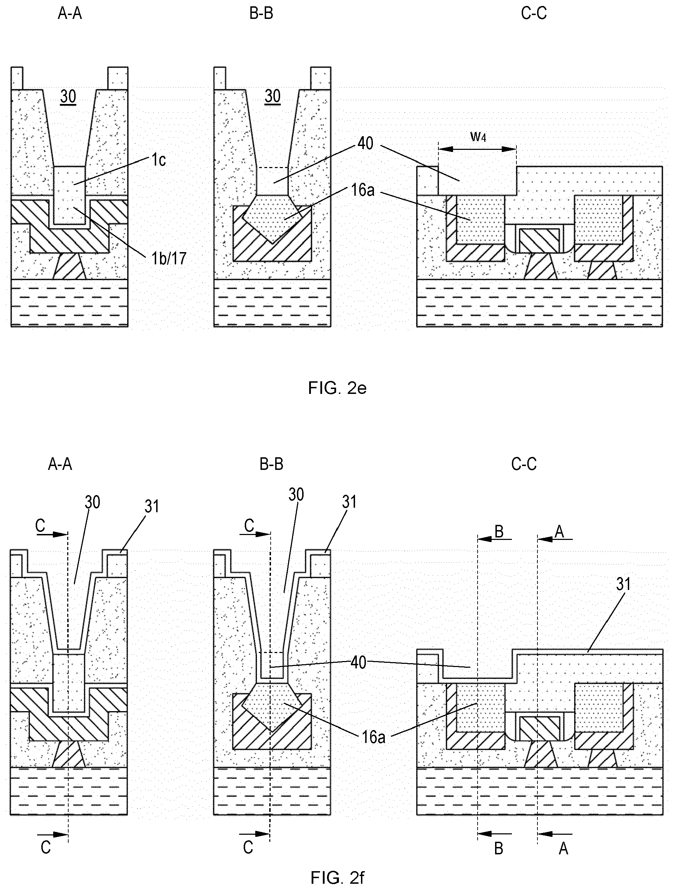

An additional lithography and etch step is now applied, see Figure 2e, to the effect that the middle portion 1c of the fin is locally removed at the bottom of the trench 30 to create a via opening 40 having a width w₄ in the direction of the fin, wherein w₄ at least partially overlaps the doped drain region 16a. In the direction perpendicular to the fin, the opening 40 is self-aligned to the original fin, as the etch recipe is again selective relative to the SiO₂.

With reference to Figure 2f, the dielectric liner 31 is deposited, covering the sidewalls and bottom of the trench 30, and the sidewalls and bottom of the opening 40.

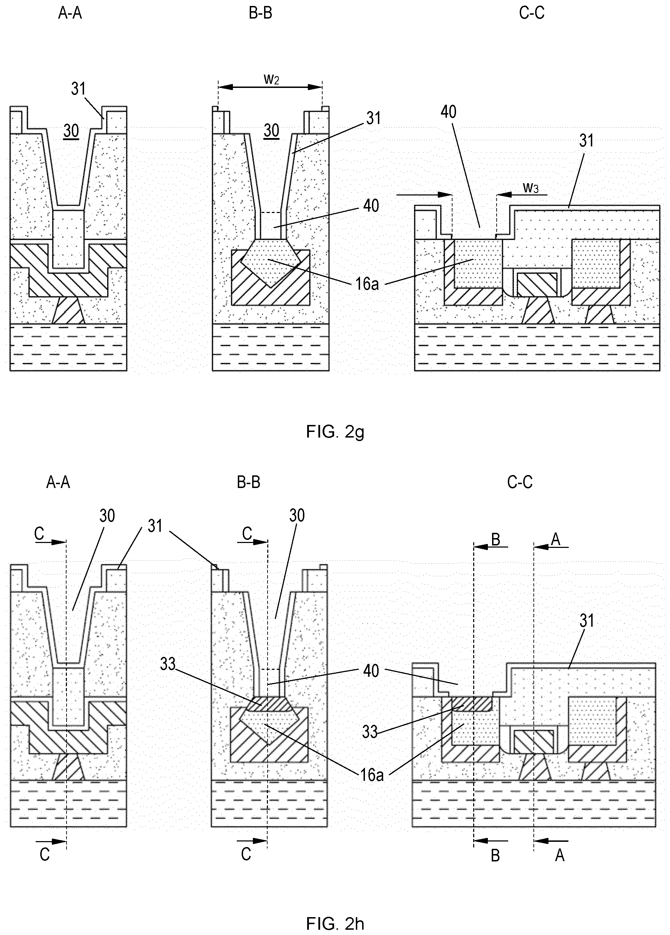

A further lithography and etch step is then performed, in an area having width w₃ in the direction of the fin and w₂ in the direction perpendicular thereto, and using a plasma etch that removes the liner 31 from the level surfaces exposed in said area while leaving sufficient liner material on the vertical and inclined surfaces. The result thereof is shown in Figure 2g.

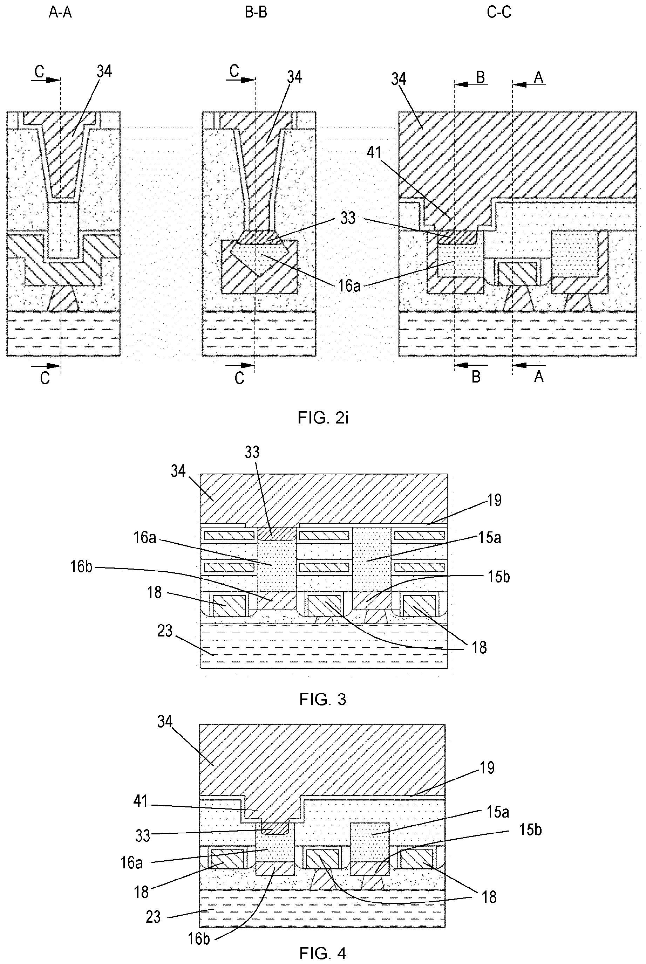

Silicidation 33 of the exposed region takes place in the same manner as described for the first embodiment, see Figure 2h, which is followed by the metal fill step, illustrated in Figure 2i, to form the rail 34, connected to the drain 16 by a via interconnect 41.

Figures 3 and 4 show examples of structures comprising respectively several nano-sheet devices and several finFETs with consecutive source and drain areas 15,16 separated by regularly spaced gates 18. The metal contacts 15b,16b are now wrapped around only the top and two sidewalls of the doped regions 15a,16a. The rail 34 is produced in the same way as described above.

The invention is not limited to the devices described above and shown in the drawings. Any semiconductor device (diode, bipolar transistor,..) having at least two terminals (in the sense described above) can be contacted by a rail produced in accordance with the invention, i.e. a rail that is self-aligned to a fin used as the starting point for producing the device. The rail is self-aligned in the sense that the rail is produced by removing the base portion of the fin and replacing it by the rail material. A component (IC chip or other) according to the invention is characterized by the fact that it comprises at least one device connected at its back side to a buried rail lying underneath the terminals of the device and aligned to said terminals in the direction of the current flow between the terminals.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A method for producing an interconnect rail (34) that is electrically connected to a semiconductor device comprising at least two terminals (15,16) for conducting current into or out of the device, wherein the device is produced on the front side of a semiconductor wafer (2) by processing a top portion (1b) of a semiconductor fin (1) comprising said top portion (1b) and a base portion (1a) that is uniform with the semiconductor wafer (2) and that is embedded in a dielectric material (8), and wherein the interconnect rail (34) is configured to connect a terminal (15,16) of the device to the back side of a substrate (5) obtained by thinning the wafer (2),
**characterized in that** the production of the interconnect rail (34) takes place after producing the device and thinning the wafer (2), and includes removing the base portion (1a) of the fin (1) selectively with respect to the dielectric material (8) and filling a trench (30) obtained by said selective removal, to thereby form the interconnect rail (34), so that the rail is aligned to the top portion (1b) of the fin (1).

2. The method according to claim 1, wherein a dielectric liner (31) is produced on the sidewalls and the bottom of the trench (30), and wherein the liner is locally removed on the bottom of the trench to thereby expose a terminal (15,16) of the device prior to filling the trench (30).

3. The method according to claim 2, wherein :
- the device is a nano-sheet field effect transistor,
- said terminals include a source terminal (15) and a drain terminal (16),
- the source and drain terminal each comprise a doped semiconductor region (15a, 16a) in said top portion (1b) of the fin, and a contact (15b, 16b) formed at least on top of said doped semiconductor region (15a,16a),
- the doped semiconductor regions (15a,16a) are formed directly on the base portion (1a) of the fin, so that said regions are exposed at the bottom of the trench (30),
- the device further comprises :
▪ a channel (17) between the source and drain regions, and configured to conduct current in the direction of the fin, through a plurality of nano-sheets formed of the semiconductor material of the substrate (5),
▪ a gate (18) wrapped around the nano-sheets and separated from the channel by a gate dielectric (19),
- after depositing the liner (31) on the sidewalls and the bottom of the trench (30), the liner (31) is locally opened in an area overlapping one of said doped semiconductor regions (15a,16a), thereby exposing at least part of said region,
- the material of the doped semiconductor region is at least partially transformed into a first electrically conductive material (33), prior to filling the trench with a second electrically conductive material to thereby form the interconnect rail (34).

4. The method according to claim 1 wherein a via opening (40) is locally produced at the bottom of the trench (30), to thereby expose a terminal of the device, prior to filling the trench.

5. The method according to claim 4, wherein :
- the device is a finFET transistor,
- said terminals include a source terminal (15) and a drain terminal (16),
- the source and drain terminals each comprise a doped semiconductor region (15a,16a) in said top portion of the fin, and a contact (15b,16b) formed at least on top of said region,
- the device further comprises :
▪ a channel (17) between the source and drain regions, and configured to conduct current in the direction of the fin,
▪ a gate (18) separated from the channel by a gate dielectric (19),
- the via opening (40) is produced through the bottom of the trench (30), overlapping one of said doped semiconductor regions,
- a dielectric liner (31) is deposited on the sidewalls and bottom of the trench (30) and of the via opening (40),
- the liner (31) is removed from a part of the bottom of the via opening (40), thereby exposing at least part of one of said doped semiconductor regions,
- the material of the doped semiconductor region is partially transformed into a first electrically conductive material, prior to filling the via opening (40) and the trench (30) with a second electrically conductive material to thereby form the rail (34).

6. The method according to claim 3 or 5, wherein the doped semiconductor regions (15a,16a) are silicon regions, and wherein the material of said exposed region is transformed into a metal silicide, by depositing a metal layer and by allowing the metal to react with the silicon of said exposed region.

7. The method according to any one of the preceding claims, wherein the semiconductor wafer (2) is formed of a base wafer (3), an etch stop layer (4) and a substrate (5), and wherein the fin is uniform with the substrate (5), and wherein thinning the wafer comprises removing the base wafer (3) and the etch stop layer (4) relative to the substrate (5).

8. A semiconductor component comprising :
- a semiconductor substrate (5),
- a device on the front side of the substrate, the device comprising at least two terminals (15,16) for conducting current into or out of the device,
- an interconnect rail (34) buried in the substrate and oriented parallel to the current flow direction between the terminals,
**characterized in that** the terminals are located above the rail and aligned thereto along said flow direction, and wherein one of the terminals is electrically connected to the rail.

9. The component according to claim 8, wherein
- the device is a nano-sheet field effect transistor,
- said terminals include a source terminal (15) and a drain terminal (16),
- the device further comprises :
▪ a channel (17) between the source and drain regions, and configured to conduct current in the direction of the fin, through a plurality of nano-sheets formed of the semiconductor material of the substrate (5),
▪ a gate (18) wrapped around the nano-sheets and separated from the channel by a gate dielectric (19).

10. The component according to claim 8, wherein
- the device is a finFET transistor,
- said terminals include a source terminal (15) and a drain terminal (16),
- the device further comprises :
▪ a channel (17) between the source and drain regions, and configured to conduct current in the direction of the fin,
▪ a gate (18) separated from the channel by a gate dielectric (19).
